# EUROPEAN PATENT APPLICATION

(11) **EP 4 656 768 A2**
(43) Date of publication of application: **03.12.2025**
(21) Application number: 25168494.0
(22) Date of filing: 04.04.2025
(51) Int. Cl.: C23C 16/32, C30B 1/00, C30B 28/14, C30B 29/36, H01L 21/02, C01B 32/186, C04B 35/00, C04B 35/52, C04B 38/00, C23C 16/455, C23C 16/46, C23C 16/48

(54) **METHOD AND SYSTEM FOR OBTAINING HIGH-QUALITY CUBIC SILICON CARBIDE**

(30) Priority: 09.04.2024 IT 202400007876
(71) Applicant: LPE S.p.A., 20021 Baranzate (MI) (IT)
(72) Inventor: Azadmand, Mani, Catania, Sicily (IT); Mauceri, Marco, Catania, Sicily (IT); Crippa, Danilo, Novara (IT); Preti, Silvio Roberto Mario, Baranzate, Milan (IT); Valente, Gianluca, Milan (IT)
(74) Representative: Bird & Bird Società tra Avvocati S.r.l.

(57) **Abstract**

A method (200) is disclosed. The method (200) comprises:
- providing (205) a carbonaceous substrate (S);
- performing (210) a chemical vapor deposition process on the carbonaceous substrate using a mixture of precursor gasses comprising:
a silicon precursor gas comprising trichlorosilane, and
a carbon precursor gas selected from carbon-carbon double bond hydrocarbons and carbon-carbon triple bond hydrocarbons;

- through said chemical vapor deposition process, forming (215) a polycrystalline cubic silicon carbide layer with crystallographic orientation {111}.

## Description

### TECHNICAL FIELD

The present disclosure relates to the field of semiconductor materials. Particularly, the present disclosure relates to a method and system for growth of high-quality cubic silicon carbide.

### BACKGROUND ART

Power devices are key components in a variety of power electronic systems.

Silicon-based power devices have improved significantly over the past several decades, but these devices are now approaching performance limits imposed by silicon properties, and further progress can only be made by migrating to more robust semiconductor materials.

Silicon carbide (SiC) is a wide band gap semiconductor material satisfying requirements to replace silicon. It exhibits about 10 times higher breakdown electric field strength and 3 times higher thermal conductivity than silicon, making it especially attractive for high-power and high-temperature devices.

As known, SiC can take many crystal structures (polytypes). Polytypes are essentially variants of a same chemical compound that have same crystal structure in two spatial directions and differ in the third spatial direction.

SiC polytypes having hexagonal crystal structures (also referred to as hexagonal SiC), such as 4H-SiC or 6H-SiC, are known.

SiC polytype having a cubic crystal structure (also referred to as cubic SiC or 3C-SiC or β-SiC) is also known.

3C-SiC is better suited for some electronic device manufacturing, in that it exhibits superior physical properties compared to the hexagonal SiC. Just as an example, 3C-SiC features lower costs and higher electron mobility than 4H-SiC.

Crystallographic orientation of 3C-SiC may affect performance and applications. Just as an example, 3C-SiC with crystallographic orientation {111} could be used for manufacturing microelectronic devices, due to low or relatively low surface roughness and high or relatively high electron mobility resulting from crystallographic orientation {111}. Just as another example, 3C-SiC with crystallographic orientation {111} could be used for applications that require high-quality epitaxial growth, such as manufacturing of high-performance transistors.

US10358741 discloses an inexpensive seed material for liquid phase epitaxial growth of silicon carbide. A seed material for liquid phase epitaxial growth of a monocrystalline silicon carbide includes a surface layer containing a polycrystalline silicon carbide with a 3C crystal polymorph. Upon X-ray diffraction of the surface layer thereof, a first-order diffraction peak corresponding to a {111} crystal plane is observed as a diffraction peak corresponding to the polycrystalline silicon carbide with a 3C crystal polymorph but no other first-order diffraction peak having a diffraction intensity of 10 percent or more of the diffraction intensity of the first-order diffraction peak corresponding to the {111} crystal plane is observed.

JP2007049201 discloses providing a multilayer silicon carbide wafer which is detected by a photosensor and is high in purity by a method wherein the multilayer silicon carbide wafer is composed of silicon carbide layers which are laminated by a CVD method, and each having different light transmittance.

WO2022122877 discloses a CVD method for preparing a layer comprising uniform {111} oriented SiC crystals, wherein at least part of the layer is formed from a gas mixture containing a silicon source and an aromatic carbon source.

### SUMMARY

Hexagonal SiC (such as 6H-SiC and 4H-SiC) is already available on the market of power devices. However, 3C-SiC is still not widely used in the industry, essentially due to the lack of commercially available 3C-SiC substrates.

This is mostly due to a high or relatively high density of defects in the crystalline structure of 3C-SiC, such as inclusions of other polytypes, twinned domains and stacking faults.

A polycrystalline cubic (3C) silicon carbide (SiC) layer with crystallographic orientation {111} (hereinafter, {111} oriented polycrystalline 3C SiC layer) may be obtained by a chemical vapor deposition process: a carrier gas is mixed with a gas containing carbon atoms *(i.e.,* a carbon precursor gas) and with a gas containing silicon atoms *(i.e.,* silicon precursor gas), thereby obtaining a corresponding mixture of precursor gasses (hereinafter, gas mixture), and the gas mixture is delivered into a reaction chamber, where growth or deposition takes place on a heated substrate.

The Applicant has found that known chemical vapor deposition processes are not satisfactory, in that no uniform distribution of {111} oriented crystalline structures (grains) can be obtained.

It is understood that the formation of a polycrystalline cubic silicon carbide layer with crystallographic orientation {111}, means that the {111} orientation is perpendicular with respect to the surface of the layer being grown.

Moreover, in some applications the {111} oriented polycrystalline 3C SiC layer may be used as a source material for growth of other SiC polytypes 4H-SiC. In these applications, individual grain properties in the {111} oriented polycrystalline 3C SiC layer is an important parameter, and low or relatively low deviations from a fully {111} grain orientation distribution may determine suboptimal results for the 4H-SiC.

In view of the above, the Applicant has devised a method (and a system) capable of obtaining a {111} oriented polycrystalline 3C SiC layer with controlled grain orientations, which is capable of large-scale industrial production.

One or more aspects of the present disclosure are set out in the independent claims, with advantageous features of the same disclosure that are indicated in the dependent claims, whose wording is enclosed herein verbatim by reference (with any advantageous feature being provided with reference to a specific aspect of the present disclosure that applies mutatis mutandis to any other aspect thereof).

An aspect of the present disclosure relates to a method comprising:
- providing a carbonaceous substrate;
- performing a chemical vapor deposition process on the carbonaceous substrate using a mixture of precursor gasses comprising:
   a silicon precursor gas comprising trichlorosilane, and
   a carbon precursor gas selected from carbon-carbon double bond hydrocarbons and carbon-carbon triple bond hydrocarbons;
- through said chemical vapor deposition process, forming a polycrystalline cubic silicon carbide layer with crystallographic orientation {111}.

According to an embodiment, the carbon precursor gas is ethylene.

According to an embodiment, a molar ratio between carbon and silicon in said mixture of precursor gasses is between 0.46 and 1.

According to an embodiment, said mixture of precursor gasses comprises a carrier gas, and a molar ratio between silicon and carrier gas is between 2 % and 5 %.

According to an embodiment, the chemical vapor deposition process is performed at a temperature between 1150°C and 1350°C.

According to an embodiment, the chemical vapor deposition process is performed at a pressure between 3 KPa and 40 KPa, preferably at a pressure of 3-10 KPa.

According to an embodiment, the carbonaceous substrate comprises isotropic graphite.

According to an embodiment, the layers obtained with the present method may be 10 micrometer -1000 micrometers thick.

They may also grow on both (opposite) sides of the carbonaceous substrate.

Another aspect of the present disclosure relates to a system comprising a reaction chamber, a support member adapted to support a substrate, a heating apparatus configured to heat the support member during a chemical vapor deposition process, and a gas delivery system. During the chemical vapor deposition process, the gas delivery system is configured to mix a carrier gas with a carbon precursor gas and with a silicon precursor gas thereby obtaining a corresponding mixture of precursor gasses, and to deliver the mixture of precursor gasses into the reaction chamber thereby obtaining a polycrystalline cubic silicon carbide layer with crystallographic orientation {111}. The silicon precursor gas comprises trichlorosilane and the carbon precursor gas is selected from carbon-carbon double bond hydrocarbons and carbon-carbon triple bond hydrocarbons.

### BRIEF DESCRIPTION OF THE DRAWINGS

These and other features and advantages of the disclosure will be made apparent by the following description of some exemplary and non-limitative embodiments thereof. For its better intelligibility, the following description should be read making reference to the attached drawings, wherein:
Figure 1 schematically shows a system according to embodiments of the present disclosure;
Figure 2 shows a method implemented by means of the system of Figure 1 according to embodiments of the present disclosure.

### DETAILED DESCRIPTION OF EMBODIMENTS

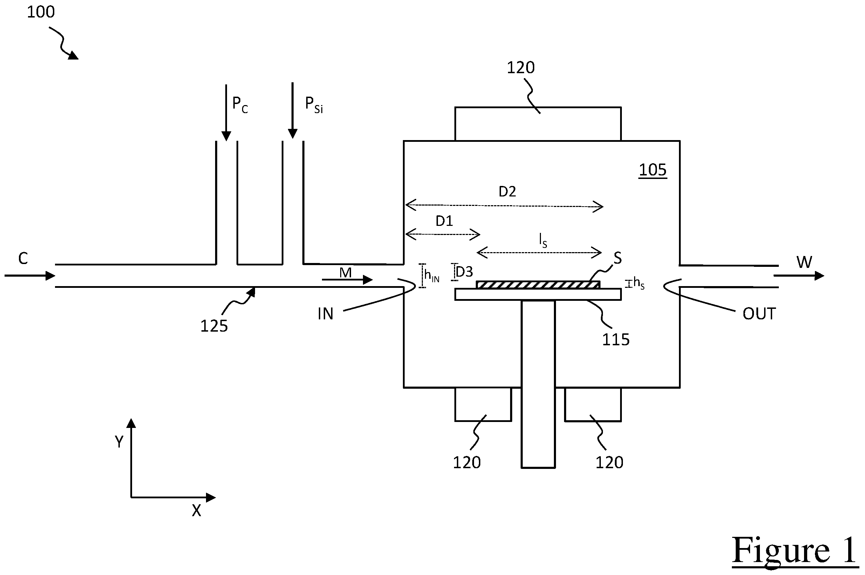

With reference to the drawings, Figure 1 schematically shows a system 100 according to embodiments of the present disclosure.

In the following, when one or more features of the system 100 (and of a method implemented by it) are introduced by the wording "according to an embodiment", they are to be construed as features additional or alternative to any features previously introduced, unless otherwise indicated and/or unless there is evident incompatibility among feature combinations that is immediately apparent to the person skilled in the art.

In the following, directional terminology (*e.g*., upper, lower, longitudinal, and vertical) in connection with the system 100 relates to its orientation in the figure, which is assumed to be an exemplary orientation of use. In particular, the directional terminology in connection with the system 100 relates to the mutually orthogonal reference directions X and Y (hereinafter referred to as longitudinal and vertical directions, respectively).

According to an embodiment, the system 100 is configured to implement a Chemical Vapor Deposition (CVD) process aimed at growing or depositing silicon and carbon on a substrate S to obtain or synthesize a polycrystalline cubic (3C) silicon carbide (SiC) layer with crystallographic orientation {111} (hereinafter, {111} oriented polycrystalline 3C SiC layer).

According to an embodiment, the system 100 comprises a reaction chamber 105 (which identifies an inner cavity).

According to an embodiment, the system 100 comprises one or more insulating coverings (not shown) configured to thermally insulate the reaction chamber 105 from an external environment.

According to an embodiment, the system 100 comprises a support member (referred to as "susceptor") 115 adapted to support the substrate S. According to an embodiment, the susceptor 115 is a flat or substantially flat member. According to an embodiment, the susceptor 115 is formed in or comprises a material having a high or relatively high melting temperature (such as graphite).

According to an embodiment, the system 100 comprises a heating apparatus 120 configured to heat the susceptor 115 (and, hence, the substrate S supported by it).

According to an embodiment, the heating apparatus 120 may be or comprise an inductive heating apparatus. Just as an example, the heating apparatus 120 may be or comprise one or more radio frequency energized coils.

According to an embodiment, the heating apparatus 120 may be or comprise a resistive heating apparatus. Just as an example, the heating apparatus 120 may be or comprise one or more carbide covered resistors.

Without losing generality, the heating apparatus 120 may be arranged to heat the substrate S at a single side thereof (in this implementation, the susceptor is usually referred to as cold wall susceptor) or at different sides thereof (in this implementation, the susceptor is usually referred to as hot wall susceptor).

According to an embodiment, the system 100 comprises a gas delivery system 125.

According to an embodiment, the gas delivery system 125 is configured to mix a carrier gas C with a gas containing carbon atoms (*i.e.,* a carbon precursor gas) P_{C} and with a gas containing silicon atoms (*i.e.,* silicon precursor gas) P_{Si}, thereby obtaining a corresponding mixture of precursor gasses (hereinafter, gas mixture) M.

According to an embodiment, the gas delivery system 125 is configured to deliver the gas mixture M into the reaction chamber 105 (*e.g.,* through a corresponding chamber inlet IN), where the growth or deposition takes place on the heated substrate S, and to exhaust corresponding waste products W outside the reaction chamber 105 (*e.g.,* through a corresponding chamber outlet OUT).

According to an embodiment, as illustrated, the reaction chamber 105 and the gas delivery system 125 are arranged in such a way that the gas mixture M hits or invests the substrate S longitudinally to a main surface thereof (in this implementation, the reaction chamber is usually referred to as horizontal flux reaction chamber). In this embodiment, the susceptor 115 supports the substrate S parallel or substantially parallel to the longitudinal direction X.

According to an embodiment the substrate S may be placed, with respect to the chamber inlet IN, according to one or more positional criteria identifying one or more geometrical parameters of the system 100.

According to an embodiment, considering the longitudinal direction X, the geometrical parameters may comprise one or more (preferably all) among a distance D1 between the chamber inlet IN and a proximal end of the substrate S (*i.e.,* an end of the substrate that is closer to the chamber inlet IN), a distance D2 between the chamber inlet IN and a distal end of the substrate S (*i.e.,* an end of the substrate that is farther from the chamber inlet IN), and a longitudinal extent lₛ of the substrate S.

According to an embodiment, considering the vertical direction Y, the geometrical parameters may comprise one or more (preferably all) among a distance D3 between the substrate S (*e.g.,* the main or upper surface thereof) and an upper end of the chamber inlet IN (*i.e.,* an end of the chamber inlet IN that is farther from the substrate S), a vertical extent h_{IN} of the chamber inlet IN, and vertical extent h_{S} of the substrate S.

According to an embodiment, not illustrated, the reaction chamber 105 and the gas delivery system 125 are arranged in such a way that the gas mixture M hits or invests the substrate S transversally to the main surface thereof (in this implementation, the reaction chamber is usually referred to as vertical flux reaction chamber).

According to the principles of the present disclosure, the substrate S (for example in the form of a plate or disc) is or comprises a carbonaceous substrate, the carbon precursor gas P_{C} is selected from carbon-carbon double bond hydrocarbons (such as alkenes) and carbon-carbon triple bond hydrocarbons (such as alkynes), and the silicon precursor gas P_{Si} is or comprises trichlorosilane (HSiCl₃). According to an embodiment, the substrate S (for example in the form of a plate or disc) is or comprises a carbonaceous substrate, the carbon precursor gas P_{C} is or comprises ethylene, and the silicon precursor gas P_{Si} is or comprises trichlorosilane.

The use of ethylene as the carbon precursor gas P_{C} and the use of the trichlorosilane as the silicon precursor gas P_{Si} allows reducing safety hazards as compared to known precursor gasses.

The use of ethylene as the carbon precursor gas P_{C} and the use of the trichlorosilane as the silicon precursor gas P_{Si} also allows achieving an increased growth rate of crystalline structures (or grains) with crystallographic orientation {111} (hereinafter, {111} oriented grains). Without losing generality, the growth rate of the {111} oriented grains may be of the order of 100µm/h (or higher).

According to an embodiment, the carbonaceous substrate may be or comprise isotropic graphite and/or any other carbonaceous material exhibiting same or similar chemical/physical proprieties, such as high purity (< 5 ppm of impurities), high operating temperatures, high chemical resistance (*e.g*., so as to reduce corrosion with silicon carbide vapor), easy machining (*i.e.,* possibility of obtaining complex or relatively complex shapes, with very tight tolerances and various available surface finishing processes), and/or low coefficient of thermal expansion (CTE), such as 4.2-5 10⁻⁶/K, and density of 1.6-1.9 mg/m³. The use of isotropic graphite has the advantage of compactness uniformity along the substrate, which is an important aspect for heat distribution, thermal uniformity, and impurity level.

According to an embodiment, the carbonaceous substrate, such as the carbonaceous substrate comprising isotropic graphite, may be formed by using isostatic process.

Without losing generality, the carbonaceous substrate comprises a composite substrate.

According to an embodiment, the carrier gas C may be or comprise hydrogen (H₂). Without losing generality, the carrier gas C may be or comprise one or more inert gasses (such as argon), or a combination between one or more inert gasses and hydrogen.

In the following, specific values and value ranges of process (or growth) parameters (such as molar ratios, temperature, pressure) resulting from experimental tests carried out by the Applicant by using ethylene as the carbon precursor gas P_{C} and trichlorosilane as the silicon precursor gas P_{Si}, will be discussed by way of preferred and not limiting embodiments only. In addition, based on the experimental tests, the values or value ranges discussed for each process parameter provide advantageous effects both when considered alone and when considered in combination with the values or value ranges of one or more other process parameters.

According to an embodiment, a molar ratio between carbon and silicon in the gas mixture M (*i.e.,* the ratio of the mole quantities of carbon and silicon) is between 0.46 and 1. According to a preferred embodiment, the molar ratio between carbon and silicon in the gas mixture M is equal to 0.61, which has been experimentally found to minimize or at least drastically reduce the risks of <220> oriented grains and/or non-reacted Si.

According to an embodiment, a molar ratio between silicon and carrier gas is between 2% and 5%, preferably between 3% - 4%. According to a preferred embodiment, the molar ratio between silicon and carrier gas is equal to 3.4%, which has been experimentally found to minimize or at least drastically reduce the risks of <220> oriented grains and/or non-reacted Si.

According to an embodiment, the CVD process is performed at a temperature sufficiently low to avoid formation of grains with crystallographic orientation <220>, and sufficiently high to avoid formation of amorphous or low-quality grains. According to an embodiment, the CVD process is performed at a temperature between 1150°C and 1350°C. According to preferred embodiments, the CVD process is performed between 1200 °C and 1300 °C, and preferably at a temperature of 1250°C or at a temperature of 1270°C; these temperatures have been experimentally found to minimize or at least drastically reduce the risks of <220> oriented grains and/or non-reacted Si.

According to an embodiment, the CVD process is performed at a pressure between 3 kPa and 40 kPa. According to a preferred embodiment, the CVD process is performed at a pressure of 3-10 kPa, such as about 5 KPa. In this respect, the Applicant has found that performing the CVD processes with a pressure in such a pressure range, *i.e.,* at a pressure lower or significantly lower (such as the preferred pressure of 5 KPa) than conventional pressures conventionally deemed necessary for obtaining {111} oriented grains, is advantageous in that the risks of <220> oriented grains and/or non-reacted Si are minimized or at least drastically reduced.

As discussed above, the substrate S may be placed, with respect to the chamber inlet IN, according to one or more positional criteria identifying one or more geometrical parameters of the system 100.

In the following, specific values and value ranges of geometrical parameters (such as the distances D1, D2, D3, the longitudinal l_{S} and vertical h_{S} extents of the substrate S, and the vertical extent h_{IN} of the chamber inlet IN) resulting from experimental tests carried out by the Applicant by using ethylene as the carbon precursor gas P_{C} and trichlorosilane as the silicon precursor gas P_{Si}, will be discussed by way of preferred and not limiting embodiments only. In addition, based on the experimental tests, the values or value ranges discussed for each geometrical parameter provide advantageous effects (particularly, on interaction between the gas mixture M and the substrate S) both when considered alone and when considered in combination with the values or value ranges of one or more other geometrical parameters.

Particularly, the specific values and value ranges of geometrical parameters mentioned below have been found to have an important impact on the quality and uniformity of the deposited material.

According to an embodiment, the distance D1 (*i.e.,* the distance, along the longitudinal direction X, between the proximal end of the substrate S and the chamber inlet IN) is between 40 mm and 100 mm. The preferred value of distance D1 has been found to be particularly important for obtaining the desired grains orientation.

According to an embodiment, the distance D2 (*i.e.,* the distance, along the longitudinal direction X, between the distal end of the substrate S and the chamber inlet IN) is between 190 mm and 450 mm.

According to an embodiment, the distance D3 (*i.e.,* the vertical distance between the substrate S and the upper end of the chamber inlet IN) is preferably between 20 mm and 40 mm. In this embodiment, there is no or substantially no distance, along the vertical direction Y, between the substrate S and the lower end of the chamber inlet IN).

According to an embodiment, the longitudinal extent l_{S} of the substrate S is between 100 mm and 200 mm.

According to an embodiment, the vertical extent h_{S} of the substrate S is between 1.2 mm and 1.8 mm.

According to an embodiment, the vertical extent h_{IN} of the chamber inlet IN is between 22 mm and 34 mm.

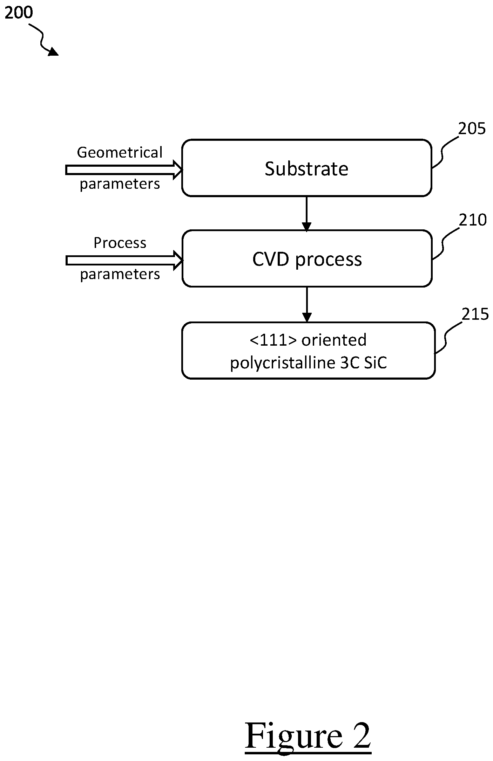

With reference to Figure 2, it shows a method 200 according to embodiments of the present disclosure.

According to an embodiment, the method 200 is implemented by means of the system 100, although this should not be construed limitatively.

According to an embodiment, the method 200 comprises providing the carbonaceous substrate S (step 205), the carbonaceous substrate S for example being or comprising isotropic graphite.

According to an embodiment, said providing the carbonaceous substrate comprises placing the carbonaceous substrate S (within the reaction chamber 105, on the susceptor 115) parallel or substantially parallel to the longitudinal direction X (in such a way that the gas mixture M hits or invests the carbonaceous substrate S longitudinally to the main surface thereof.

According to an embodiment, said providing the carbonaceous substrate S comprises setting the geometrical parameters of the system 100 or at least a subset thereof (such as one or more among the distances D1, D2, D3 between the carbonaceous substrate S and the chamber inlet IN, the longitudinal l_{S} and vertical h_{S} extents of the carbonaceous substrate S, and the vertical extent h_{IN} of the chamber inlet IN).

According to an embodiment, the method 200 comprises performing a CVD process on the carbonaceous substrate S using a mixture of precursor gasses (*i.e.,* the gas mixture M) comprising trichlorosilane as the silicon precursor gas P_{Si} and ethylene (or, alternatively, other alkenes or alkynes) as the carbon precursor gas P_{C} (step 210), and forming, through the CVD process, a {111} oriented polycrystalline 3C SiC layer (step 215).

According to an embodiment, said performing a CVD process on the carbonaceous substrate S comprises setting the process parameters (including, but not limited to, one or more among molar ratio between carbon and silicon in the gas mixture M, molar ratio between silicon and carrier gas, temperature, pressure and flow speed of the gas mixture M).

According to an embodiment, said performing a CVD process on the carbonaceous substrate S comprises enabling or activating or turning on the gas delivery system 125 to mix the carrier gas C with the carbon precursor gas P_{C} and the silicon precursor gas P_{Si}, thereby obtaining the corresponding gas mixture M, and to deliver the gas mixture M into the reaction chamber 105, and enabling or activating or turning on the heating apparatus 120, so as to heat the support member 115 (and, hence, the substrate S thereon) while the gas mixture M enters the reaction chamber 105, thereby obtaining the {111} oriented polycrystalline 3C SiC layer on the substrate S.

The method 200 allows obtaining a {111} oriented polycrystalline 3C SiC layer with high quality and evenly distributed {111} oriented grains.

The {111} oriented polycrystalline 3C SiC layer so obtained is therefore adapted to be used as a source material for obtaining other SiC polytypes (such as 4H-SiC) having high quality.

Naturally, in order to satisfy local and specific requirements, a person skilled in the art may apply to the disclosure described above many logical and/or physical modifications and alterations. More specifically, although the present disclosure has been described with a certain degree of particularity with reference to preferred embodiments thereof, it should be understood that various omissions, substitutions and changes in the form and details as well as other embodiments are possible. In particular, different embodiments of the disclosure may even be practiced without the specific details set forth in the preceding description for providing a more thorough understanding thereof; on the contrary, well-known features may have been omitted or simplified in order not to encumber the description with unnecessary details. Moreover, it is expressly intended that specific elements and/or method steps described in connection with any disclosed embodiment of the disclosure may be incorporated in any other embodiment.

More specifically, the present disclosure lends itself to be implemented through an equivalent method (by using similar steps, removing some steps being not essential, or adding further optional steps); moreover, the steps may be performed in different order, concurrently or in an interleaved way (at least partly).

In addition, the system may have a different structure or include equivalent components. Moreover, any component of the system may be separated into several elements, or two or more components may be combined into a single element; furthermore, each component can be replicated to support the execution of the corresponding operations in parallel. It should also be noted that (unless otherwise indicated) any interaction between different components generally does not need to be continuous and may be either direct or indirect through one or more intermediaries.

## Claims

1. Method (200) comprising:
- providing (205) a carbonaceous substrate (S);
- performing (210) a chemical vapor deposition process on the carbonaceous substrate using a mixture of precursor gasses comprising:
a silicon precursor gas comprising trichlorosilane, and
a carbon precursor gas selected from carbon-carbon double bond hydrocarbons and carbon-carbon triple bond hydrocarbons;
- through said chemical vapor deposition process, forming (215) a polycrystalline cubic silicon carbide layer with crystallographic orientation {111}.

2. Method (200) according to claim 1, wherein the carbon precursor gas is ethylene.

3. Method (200) according to claim 2, wherein a molar ratio between carbon and silicon in said mixture of precursor gasses is between 0.46 and 1.

4. Method (200) according to claim 2 or 3, wherein said mixture of precursor gasses comprises a carrier gas, and wherein a molar ratio between silicon and carrier gas is between 2 % and 5 %.

5. Method (200) according to any claim from 2 to 4, wherein the chemical vapor deposition process is performed at a temperature between 1150°C and 1350°C.

6. Method (200) according to any claim from 2 to 5, wherein the chemical vapor deposition process is performed at a pressure between 3 KPa and 40 KPa.

7. Method (200) according to any claim from 2 to 6, wherein the carbonaceous substrate (S) comprises isotropic graphite.

8. System (100) comprising:
- a reaction chamber (105);
- a support member (115) adapted to support a substrate (S);
- a heating apparatus (120) configured to heat the support member (115) during a chemical vapor deposition process;
- a gas delivery system (125), during the chemical vapor deposition process the gas delivery system (125) being configured to mix a carrier gas (C) with a carbon precursor gas (P_{C}) and with a silicon precursor gas (P_{Si}) thereby obtaining a corresponding mixture of precursor gasses (M), and to deliver the mixture of precursor gasses (M) into the reaction chamber (105) thereby obtaining a polycrystalline cubic silicon carbide layer with crystallographic orientation {111},
wherein the silicon precursor gas comprises trichlorosilane and the carbon precursor gas is selected from carbon-carbon double bond hydrocarbons and carbon-carbon triple bond hydrocarbons.
